# EUROPEAN PATENT APPLICATION

(11) **EP 4 776 064 A1**
(43) Date of publication of application: **15.07.2026**
(21) Application number: 25151455.0
(22) Date of filing: 13.01.2025
(51) Int. Cl.: G03F 1/62, G03F 7/00

(54) **PROTECTIVE MEMBRANE FOR AN EXPOSURE APPARATUS AND METHOD**

(71) Applicant: ASML Netherlands B.V., 5500 AH Veldhoven (NL)
(72) Inventor: NIKIPELOV, Andrey, 5500 AH Veldhoven (NL); SCHLEGEL, Andreas, 5500 AH Veldhoven (NL); VAN MIL, Joost Johannes Lambertus, 5500 AH Veldhoven (NL)
(74) Representative: ASML Netherlands B.V.

(57) **Abstract**

There is provided a protective membrane for an exposure apparatus for semiconductor manufacturing processes, the protective membrane comprising a boron nitride nanotube core (203) and at least one containment layer (103) configured to contain particles (213) released from the core. Also provided is a component of an exposure apparatus for semiconductor manufacturing processes comprising such a protective membrane, as well as an exposure apparatus for semiconductor manufacturing processes comprising such a protective membrane or component. Also described is a method of manufacturing a protective membrane for an exposure apparatus for semiconductor manufacturing processes as well as a method of reconditioning a boron nitride nanotube protective membrane for an exposure apparatus for semiconductor manufacturing processes. Finally, the use of such a protective membrane, component, exposure apparatus or method in a semiconductor manufacturing process or apparatus therefor is also described.

## Description

### FIELD

The present invention relates to a protective membrane for an exposure apparatus for semiconductor manufacturing processes. The present invention also relates to a component of an exposure apparatus for semiconductor manufacturing processes comprising such a protective membrane, as well as to an exposure apparatus for semiconductor manufacturing processes comprising such a protective membrane. The present invention also relates to a method of manufacturing a protective membrane for an exposure apparatus for semiconductor manufacturing processes as well as a method of reconditioning a protective membrane, such as a boron nitride nanotube protective membrane, for an exposure apparatus for semiconductor manufacturing processes. The present invention also relates to the use of such a protective membrane, component, exposure apparatus or method according to any of the aforesaid in a semiconductor manufacturing process or apparatus therefor. The present invention has particular, but not exclusive application to lithographic apparatuses and methods, metrology apparatuses and methods, inspection apparatuses and methods, such as mask inspection apparatuses and methods, for example actinic mask inspection apparatuses and methods, all of which are or relate to exposure apparatuses or methods for semiconductor manufacturing processes.

### BACKGROUND

Light generated by means of a radiation source can be used by exposure apparatuses for semiconductor manufacturing processes. Examples of such exposure apparatuses are a lithographic apparatus, a metrology, or an inspection apparatus, such as a mask inspection apparatus or an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

A lithographic apparatus includes a patterning device (e.g. a mask or reticle). Radiation is provided through or reflected off the patterning device to form an image on a substrate. A membrane assembly, also referred to as a pellicle, may be provided to protect the patterning device from airborne particles and other forms of contamination. Contamination on the surface of the patterning device can cause manufacturing defects on the substrate.

Pellicles may also be provided for protecting optical components other than patterning devices. Pellicles may also be used to provide a passage for lithographic radiation between regions of the lithography apparatus which are sealed from one another. Pellicles may also be used as filters, such as spectral purity filters or as part of a dynamic gas lock of a lithographic apparatus.

A mask assembly may include the pellicle which protects a patterning device (e.g. a mask) from particle contamination. The pellicle may be supported by a pellicle frame, forming a pellicle assembly. The pellicle may be attached to the frame, for example, by gluing or otherwise attaching a pellicle border region to the frame. The frame may be permanently or releasably attached to a patterning device.

Due to the presence of the pellicle in the optical path of the EUV radiation beam, it is necessary for the pellicle to have high EUV transmissivity. A high EUV transmissivity allows a greater proportion of the incident radiation through the pellicle. In addition, reducing the amount of EUV radiation absorbed by the pellicle may decrease the operating temperature of the pellicle. Since transmissivity is at least partially dependent on the thickness of the pellicle, it is desirable to provide a pellicle which is as thin as possible whilst remaining reliably strong enough to withstand the sometimes hostile environment within a lithography apparatus.

It is therefore desirable to provide a pellicle which is able to withstand the harsh environment of a lithographic apparatus, in particular an EUV lithography apparatus. The harsh environment may include EUV radiation and plasma, induced by absorption of EUV radiation by low-pressure gases present in the lithographic apparatus. It is particularly desirable to provide a pellicle which is able to withstand higher EUV powers than previously.

Various other components within an exposure apparatus for semiconductor manufacturing processes require protection from contamination and debris. In addition to potential contaminants and debris, such components may be exposed to high temperatures, illumination by electromagnetic radiation, and to hydrogen plasma. Such conditions can cause degradation in performance or damage to such components and it is therefore desirable to provide protection against at least some of these risks.

The present invention has been devised in an attempt to address at least some of the problems identified above.

### SUMMARY OF THE INVENTION

According to a first aspect of the present disclosure, there is provided a protective membrane for an exposure apparatus for semiconductor manufacturing processes, the protective membrane comprising a boron nitride nanotube core and at least one containment layer configured to contain particles released from the core.

Pellicles comprising carbon nanotubes have been investigated as protective membranes for exposure apparatuses for semiconductor manufacturing processes due, at least in part, to their tolerance of high temperatures which means that they are able to withstand high powers, for example of 1 kW or more. Even so, carbon nanotubes are susceptible to etching when in use due to the presence of hydrogen ions and radicals in hydrogen plasma which comes into contact with the carbon nanotubes. Such etching does not necessarily occur at the same rate across the entire membrane, which can lead to transmissivity non-uniformity, which is undesirable. In addition to etching, carbon nanotubes may lose strength due to carbon-carbon bonds being broken and subsequently reforming into a more amorphous structure than the original carbon nanotubes. It has been found that boron nitride can be formed into nanotubes and that such nanotubes are suitable for use in membranes in exposure apparatuses for semiconductor manufacturing processes. It has been found that boron nitride nanotubes are significantly more robust to hydrogen plasma etching than carbon nanotubes. This is unexpected because boron and nitrogen are able to form hydrides which are volatile and would be expected to be etched from the nanotubes in a similar way to how carbon is etched by hydrogen plasma. Without wishing to be bound by scientific theory, lower etch rates for boron nitride nanotubes compared to carbon nanotubes in hydrogen plasma may relate to a lower adsorption or higher desorption of atomic hydrogen from boron nitride, in the absence of pi electrons, that are typical for graphene. However, during manufacture of boron nitride nanotubes, a significant amount of boron nitride particles, such as hexagonal boron nitride particles (h-BN) are generated that are mixed with boron nitride nanotubes and cannot be practically separated. This differs from carbon nanotube manufacture which utilises metal catalysts which can be removed from the carbon nanotubes after manufacture by evaporation of the metals to leave very pure carbon nanotubes or carbon nanotubes with some carbon contaminants, such as fullerenes, graphite, or amorphous carbon nanoparticles. It is not possible to remove h-BN particles from the boron nitride nanotubes in the same way, which leads to two main issues. Firstly, in existing manufacturing processes for boron nitride nanotubes, the mass ratio of boron nitride nanotubes to h-BN particles can be up to 50:50. This ratio can be improved to from about 100:1 to about 1000:1, by removal of relatively large h-BN particles, such as those measuring around 1 µm, but it is not possible to remove h-BN particles measuring in the order of 100nm due to the physical and chemical similarities between such particles and boron nitride nanoparticles. In use, there is therefore a risk that such h-BN particles can become dislodged and contaminate components within the exposure apparatus, such as the reticle. h-BN particles on lithographic surfaces proximate to an unprotected reticle are believed to cause reticle defectivity due to effects of EUV hydrogen plasma. The risk of reticle defectivity is increased if a boron nitride nanotube membrane comprising h-BN particles were located close to the reticle, since this is the most proximate surface to the reticle and with the highest load of EUV hydrogen plasma. In addition, it has been found that exposure to hydrogen plasma can cause explosive fragmentation of h-BN particles. Without wishing to be bound by scientific theory, it is proposed that the explosive fragmentation is due to the accumulation of hydrogen between the stacked boron nitride layers or due to preferential etching of one of boron and nitrogen from the h-BN particles resulting in the generation of compressive stress over time which ultimately leads to structural failure of the particles. Such explosive fragmentation in hydrogen plasma has not been observed for boron nitride nanotubes, carbon nanotubes, or carbon-based particles. It is believed that for carbon-based materials, etch is dominant and explosive fragmentation is practically non-existent. As such, the present invention provides for a containment layer configured to contain particles released from the membrane core. In particular, the present invention provides for containment of hexagonal boron nitride particles released from a boron nitride nanotube membrane contaminated with hexagonal boron nitride particles. In this way, h-BN particles or the fragments of such particles after explosive fragmentation, are contained by the containment layer and prevented from contaminating the exposure apparatus or its components. In addition, the presence of the at least one containment layer is also believed to reduce the rate at which hydrogen plasma can access the h-BN particles, thereby reducing the rate at which hydrogen may accumulate within or etch such particles.

The containment layer may be a porous layer. The porous layer may comprise one or both of carbon nanotubes and graphene flakes. The carbon nanotubes may be a random web of carbon nanotubes. The pores of the containment layer allow the pressure across the membrane to equalise and thereby reduce or eliminate deformation of the membrane.

An intermediate layer may be provided between the core and the containment layer. The intermediate layer may be a distinct layer. The intermediate layer may have a graduated composition, and may therefore be referred to as a graduated layer. Where the intermediate layer is a distinct layer, it may have a composition that is substantially uniform throughout. The intermediate layer may include carbon nanotubes and boron nitride nanotubes. Where the intermediate layer is a graduated layer or has a graduated composition, the composition of the layer may alter across the thickness of the layer. For example, the graduated layer may comprise carbon nanotubes and boron nitride nanotubes, and the ratio of carbon nanotubes to boron nitride nanotubes may changes from one side of the intermediate to the other. For example, at a side adjacent the core, the proportion of boron nitride nanotubes may approach one with the proportion of carbon nanotubes approaching zero, whereas at a side adjacent the containment layer, the proportion of boron nitride nanotubes may approach zero with the proportion of carbon nanotubes approaching one. It will be appreciated that the graduation of materials does not have to be linear and may, for example, change in steps.

The protective membrane may further comprise a capping layer. The at least one containment layer and/or core may comprise a capping layer. The capping layer may comprise a hydrogen plasma etch resistant material. The capping layer may comprise one or more of aluminium oxide, zirconium oxide, yttrium oxide, and yttrium silicon oxide. Such capping layer serves to improve the resistance of the containment layer to etching by hydrogen plasma when in use, thereby extending the useful lifespan of the protective membrane. The capping layer material may be applied to the carbon nanotubes or graphene flakes isotropically of anisotropically, for example mostly on the outward side of the protective membrane.

The protective membrane core may comprise boron nitride nanotubes and hexagonal boron nitride (h-BN) particles in a mass ratio of 50:1 or greater, 100:1 or greater, 250:1 or greater, 500:1 or greater, or 1000:1 or greater. Since h-BN particles are undesirable due to the risk of contamination, it is useful to reduce the amount of such particles in the core. Although it is not feasible to remove every single particle of h-BN, the containment layer is provided to capture any particles released from the core.

The containment layer may extend at least over a quality area of the membrane and may match or exceed a patterned area of a reticle protected by the membrane Pellicle membranes and reticle membranes include quality areas. The porous layer may extend over at least 50%, at least 60%, at least 70%, at least 80%, at least 90%, or at least 95% of the membrane area. The containment layer may extend over substantially the entire area of the protective membrane. The containment layer may extend over the entire area of the protective membrane.

The protective membrane may have an EUV transmissivity of 85% or greater, 90% or greater, 93% or greater, or 95% or greater.

It will be appreciated that the carbon nitride nanotube core will have a first face and a second face. The containment layer may be provided on just one face. Alternatively, both faces may comprise a containment layer configured to contain particles released from the core. Where the protective membrane is used as a pellicle membrane, it will be in close proximity to the reticle with one face facing the reticle and the other face facing away from the reticle. Where the protective membrane comprises just a single containment layer, it is preferable that this is arranged to face the reticle when in use since there are greater problems associated with a particle being released and contaminating the reticle than associated with a particle being released in another direction. By having a containment layer on both faces, it is possible to capture particles released from the core in either direction. Although the containment layer may be susceptible to etching, since the boron nitride nanotube core is resistant to etching, there is no loss of mechanical strength of the membrane core over time during nominal use. In addition, the boron nitride nanotube core can restrict diffusion of active species from the hydrogen plasma and therefore slow the rate at which the containment layer may be etched. Since the containment layer is used for containing released particles rather than for strength, the partial loss of mechanical strength of the containment layer over time is less of a concern.

The containment layer may be a uniform layer. The containment layer may be a patched layer. The containment layer may be a unitary layer. For example, where the containment layer comprises a randomly orientated carbon nanotube layer, the layer may be continuous such that it is uniform and unitary since it is formed from a single sheet of carbon nanotubes. Where the containment layer comprises graphene, the graphene may not be a single sheet, but instead may be formed of multiple smaller graphene sheets to form a patchwork.

According to a second aspect of the present disclosure, there is provided a component of an exposure apparatus for semiconductor manufacturing processes comprising the protective membrane according to the first aspect of the present disclosure.

The component may be a pellicle or a dynamic gas lock, a fiducial, a sensor, an optical element, a shield, or a reticle masking blade assembly component. The optical element may be a mirror, such as a MEMS (microelectronic mechanical system) mirror. The component may be a pellicle comprising a protective membrane according to the first aspect and a support frame.

Each of these components may be exposed to hydrogen plasma during nominal operation and it is therefore desirable to provide at least some degree of protection for such components. As mentioned, boron nitride nanotubes are very highly resistant to etching by hydrogen plasma and so providing components with a protective membrane comprising boron nitride nanotubes can protect these components from the hydrogen plasma for extended periods of time. This allows the uptime of any apparatus utilising such components to be increased.

According to a third aspect of the present disclosure, there is provided an exposure apparatus for semiconductor manufacturing processes comprising a protective membrane according to the first aspect or a component according to the second aspect. The exposure apparatus may be a lithographic apparatus, a metrology apparatus, or an inspection apparatus. The lithographic apparatus may be an EUV lithographic apparatus. The inspection apparatus may be a mask inspection apparatus, optionally an actinic mask inspection apparatus.

According to a fourth aspect of the present disclosure, there is provided a method of manufacturing a protective membrane for an exposure apparatus for semiconductor manufacturing processes, the method including: i) providing a core film, and ii) providing a first containment layer configured to contain any particles released from the core film in use on a first face of the core film.

The core film may comprise boron nitride nanotubes. The core film may include hexagonal boron nitride particles.

The method may further include providing a second containment layer configured to contain any particles released from the core film in use on a second face of the core film. The second face is opposite the first face of the core film. The first and second containment layers may be provided simultaneously or at different times.

The core film, which may be a boron nitride nanotube core film, may be supported by a solid carrier. The solid carrier material may be the same as or different to the solid carrier material used in provision of the at least one containment layer.

As mentioned, by providing a containment layer, it is possible to trap any particles released from the core and thereby prevent them from causing contamination. The membrane may be part of a pellicle. The core film may be freestanding. The core film may be supported by a frame. The core film may be attached to a frame.

At least one containment layer may be provided via one or more of a) spray coating, b) chemical vapour deposition, c) solid carrier deposition, and d) liquid carrier deposition. The core membrane may be optionally supported by its own solid carrier at least for the duration of containment layer deposition. The solid carrier layer may comprise a polymer, such as, for example, parylene, PEDOT (poly-3,4-ethylenedioxythiophene), polycarbonate, or PMMA (polymethylmethacrylate).

Spray coating is a known technique for providing a coating of one material on a surface and includes using a mist of small droplets comprising the material of the coating, such as, for example carbon nanotubes or graphene flakes in a carrier gas directed to the surface to be coated. In order to provide homogeneity of the coating, the size of droplets may be limited to, for example, from 1 to 100 µm. Additionally or alternatively, the concentration of the coating material may be limited to, for example, from 0.01 to 1 mg/cm³.

Solid carrier deposition comprises providing the containment layer on a solid carrier layer and bringing the containment layer into contact with the core film and removing the carrier layer to leave the containment layer on the core film. The contact may be direct, such that containment layer is in immediate contact with the core. The contact may be indirect, such that there is one or two carrier layers between containment layer and core film. The core film can be supported with its own solid carrier, that can be same or different material or thickness. One or both solid carrier layers may be removed later by any suitable means depending on their nature, such as via sublimation or etching.

Liquid carrier deposition comprises providing the material to form the containment layer in a liquid carrier and passing the liquid through a filter or membrane in order to form a filter cake of the material. The composition of the containment layer can be controlled by adjusting the composition of the solution. For example, the composition can be changed gradually in order to provide a graduated layer or could be changed in a stepwise manner to provide a multilayer comprising layers of distinct composition.

During liquid carrier deposition, the composition of the liquid carrier may be changed to provide a graduated protective membrane. As mentioned, in some embodiments, it may be desirable to provide a graduated protective layer. This may have the advantage of providing a stronger bond between different materials of the core and the containment layer.

During liquid carrier deposition, the density of one or both of the core film and the containment layer may be adjusted. The density may be adjusted by controlling the pressure or flow rate of the liquid carrier. A higher pressure or flow rate may serves to compress the deposited material and thereby increase its density.

Following a deposition, the solid carrier of the containment layer and/or a solid carrier layer of the core may be removed by melting, sublimation, dissolution, or etching. A frame may be added to the core film with or without one or more containment layers. The core film or one or more containment layers may be supported by the solid carrier.

As mentioned, the method may include providing a second containment layer configured to contain any particles released from the core film in use on the core film. The second containment layer may be provided on a face of the core film opposite to the first containment layer. As mentioned, some embodiments comprise a single containment layer and others comprise two containment layers. Where the protective membrane comprises two containment layers, the containment layers may sandwich the boron nitride nanotube core.

The method may include providing a capping layer. The capping layer may comprise one or more of aluminium oxide, zirconium oxide, yttrium oxide, and yttrium silicon oxide.

The method may include providing an intermediate layer between the core film and containment layer.

According to a fifth aspect of the present disclosure, there is provided a method of reconditioning a boron nitride nanotube protective membrane for an exposure apparatus for semiconductor manufacturing processes, the method including removing at least a portion of any materials other than the boron nitride nanotubes.

Since boron nitride nanotubes are extremely resilient to etching by hydrogen plasma, they are not damaged during nominal use whereas materials comprising the containment layer may become damaged over time. As such, it is possible to remove the other materials from the boron nitride nanotubes such that a new containment layer can be provided without the need to incur the additional cost of preparing new boron nitride nanotubes. In addition, re-using the boron nitride nanotubes may be advantageous since any h-BN particles which were previously not able to be removed may have been removed during use over time and so the recovered boron nitride nanotubes may have lower h-BN particle contamination. In this way, the risk associated with particles being released from the boron nitride layer may be reduced, such that reconditioning not only saves on costs but may also provide an improved membrane.

The method may include etching, reducing, or oxidising at least a portion of any materials other than the boron nitride nanotubes to remove such materials from the protective membrane. Since boron nitride nanotubes are particularly resistant to etching by hydrogen plasma, one option for removing other materials is to use hydrogen plasma etching. Similarly, if the other material is susceptible to oxidation and results in an oxide which can be readily separated from the boron nitride nanotubes, oxidation can be used. For example, where the containment layer comprises carbon, such as in the form of carbon nanotubes or graphene flakes, the carbon can be oxidised to carbon dioxide or carbon monoxide, which can readily be removed to leave the boron nitride nanotubes. Alternatively, carbon can be reduced to form methane and other volatile hydrocarbons.

Once the boron nitride nanotubes have been recovered, the method may include providing a first containment layer configured to contain any particles released from the boron nitride nanotubes in use on the boron nitride nanotubes. The first containment layer may be provided according to the method of the fourth aspect of the present disclosure. As such, the protective membrane can be formed again using the recovered boron nitride nanotubes. It will be appreciated that the method according to the fourth aspect may utilise boron nitride nanotubes recovered in accordance with the fifth aspect. Similarly, it will be appreciated that the method of reconditioning a boron nitride nanotube protective film according to the fifth aspect may include the steps described in respect of the fourth aspect.

According to a sixth aspect of the present disclosure, there is provided the use of a protective membrane according to the first aspect, a component according to the second aspect, an exposure apparatus according to the third aspect, a method according to the fourth or fifth aspect of the present disclosure in a semiconductor manufacturing process or apparatus therefor.

It will be appreciated that features described in respect of one embodiment may be combined with any features described in respect of another embodiment and all such combinations are expressly considered and disclosed herein.

### BRIEF DESCRIPTION OF THE DRAWINGS

Embodiments of the invention will now be described, by way of example only, with reference to the accompanying schematic drawing in which corresponding reference symbols indicate corresponding parts, and in which:
Figure 1 depicts a lithographic apparatus according to an embodiment of the invention;
Figures 2A to E are a schematic depiction of an existing pellicle membrane (Fig. 2A) and protective membranes according to the present invention (Figs 2B-E);
Figures 3A to C depict a schematic flow sheet of a method of forming a protective membrane according to the present invention; and
Figure 4 depicts a method of providing carbon nanotubes onto a boron nitride nanotube membrane.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements.

### DETAILED DESCRIPTION

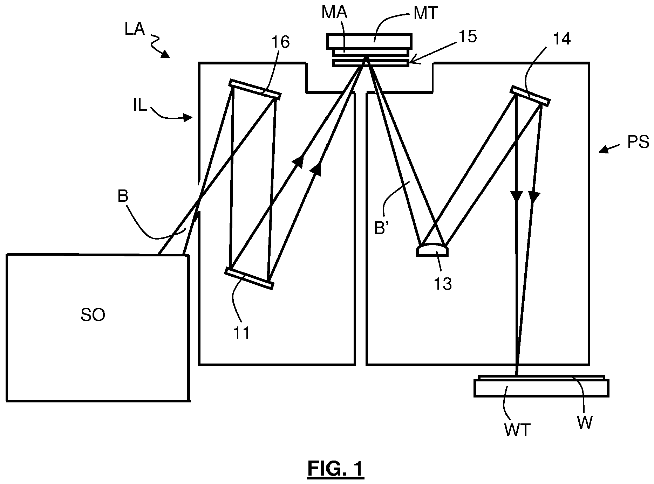

Figure 1 shows an exposure apparatus for semiconductor manufacturing processes, specifically a lithographic system including a pellicle 15 comprising a protective membrane according to one aspect of the present disclosure. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. The illumination system IL is configured to condition the radiation beam B before it is incident upon the patterning device MA. The projection system is configured to project the radiation beam B (now patterned by the mask MA) onto the substrate W. The substrate W may include previously formed patterns. Where this is the case, the lithographic apparatus aligns the patterned radiation beam B with a pattern previously formed on the substrate W. In this embodiment, the pellicle 15 is depicted in the path of the radiation and protecting the patterning device MA. It will be appreciated that the pellicle 15 may be located in any required position and may be used to protect any of the mirrors in the lithographic apparatus. The pellicle 15 may be part of a spectral purity filter.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source. A laser, which may for example be a CO₂ laser, is arranged to deposit energy via a laser beam into a fuel, such as tin (Sn) which is provided from a fuel emitter. Although tin is referred to in the following description, any suitable fuel may be used. The fuel may for example be in liquid form, and may for example be a metal or alloy. The fuel emitter may comprise a nozzle configured to direct tin, e.g. in the form of droplets, along a trajectory towards a plasma formation region. The laser beam is incident upon the tin at the plasma formation region. The deposition of laser energy into the tin creates a plasma at the plasma formation region. Radiation, including EUV radiation, is emitted from the plasma during de-excitation and recombination of ions of the plasma.

The EUV radiation is collected and focused by a near normal incidence radiation collector (sometimes referred to more generally as a normal incidence radiation collector). The collector may have a multilayer structure which is arranged to reflect EUV radiation (e.g. EUV radiation having a desired wavelength such as 13.5 nm). The collector may have an elliptical configuration, having two ellipse focal points. A first focal point may be at the plasma formation region, and a second focal point may be at an intermediate focus, as discussed below.

The laser may be separated from the radiation source SO. Where this is the case, the laser beam may be passed from the laser to the radiation source SO with the aid of a beam delivery system (not shown) comprising, for example, suitable directing mirrors and/or a beam expander, and/or other optics. The laser and the radiation source SO may together be considered to be a radiation system.

Radiation that is reflected by the collector forms a radiation beam B. The radiation beam B is focused at a point to form an image of the plasma formation region, which acts as a virtual radiation source for the illumination system IL. The point at which the radiation beam B is focused may be referred to as the intermediate focus. The radiation source SO is arranged such that the intermediate focus is located at or near to an opening in an enclosing structure of the radiation source.

The radiation beam B passes from the radiation source SO into the illumination system IL, which is configured to condition the radiation beam. The illumination system IL may include a facetted field mirror device 16 and a facetted pupil mirror device 11. The faceted field mirror device 16 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 16 and faceted pupil mirror device 11.

Following reflection from the patterning device MA the patterned radiation beam B enters the projection system PS. The projection system comprises a plurality of mirrors 13, 14 which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

The radiation sources SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

In an embodiment the membrane assembly 15 is a pellicle for the patterning device MA for EUV lithography. The membrane assembly 15 of the present invention can be used for a dynamic gas lock or for a pellicle or for another purpose. In order to ensure maximized EUV transmission and minimized impact on imaging performance it is preferred that the membrane is only supported at the border.

If the patterning device MA is left unprotected, the contamination can require the patterning device MA to be cleaned or discarded. Cleaning the patterning device MA interrupts valuable manufacturing time and discarding the patterning device MA is costly. Replacing the patterning device MA also interrupts valuable manufacturing time.

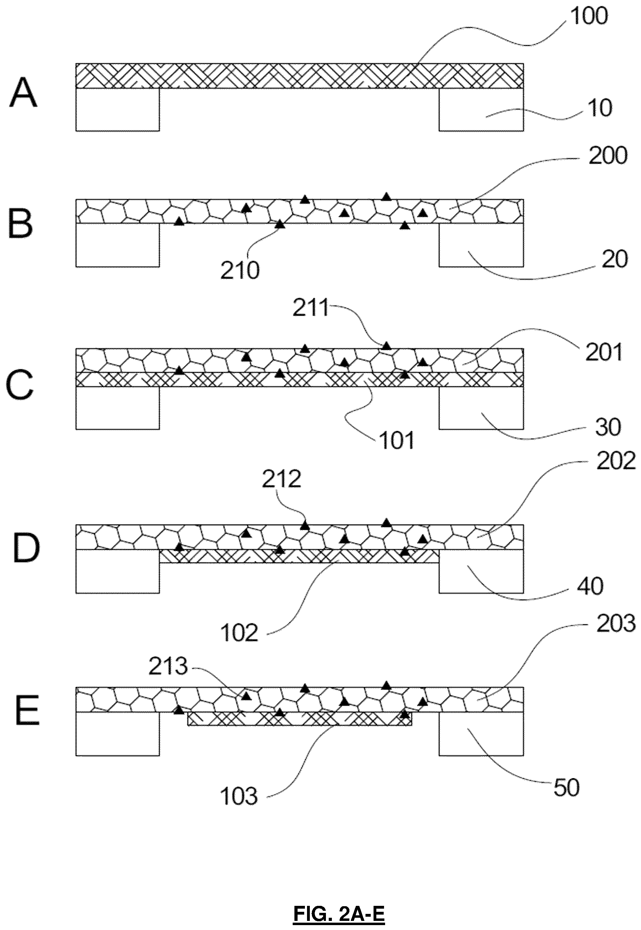

Figure 2A depicts a pellicle assembly comprising a pellicle membrane 100 supported by frame 10. Figure 2B depicts a pellicle assembly comprising a boron nitride nanotube core layer 200 supported by frame 20 that includes unwanted h-BN particles 210. As shown in Figure 2C, a containment layer 101 may be provided. In the embodiment shown in Figure 2C, the containment layer 101 is supported by the frame 30 and the boron nitride nanotube layer 201 comprising the h-BN particles 211 is provided on an upper face of the containment layer 101. Another embodiment is depicted in Figure 2D in which the boron nitride nanotube layer 202 is supported by the frame 40 and the containment layer 102 is provided on a lower face of the boron nitride nanotube layer 202. Figure 2E is similar to Figure 2D, albeit the containment layer 103 does not extend across the entire lower face of the boron nitride nanotube layer, but rather only across the quality area, that corresponds to a patterned area of the patterning device.

It will be appreciated from Figures 2C to 2E that a containment layer may only be provided on one side. Preferably, the pellicle assembly is configured to have the containment layer on the side which faces the reticle in nominal use. As mentioned, particulate contamination of the reticle is highly undesirable and so providing the containment layer on the face which faces the reticle in nominal use serves to reduce the risk of such contamination from occurring. In addition, the containment layer is shielded from the hydrogen plasma by the boron nitride nanotubes and the EUV plasma stress on the pellicle from the reticle side is an order of magnitude less than from the opposite side, such that the useful operational life of the containment layer can be extended significantly, at least in case of the containment layer comprising carbon in the form of nanotubes or graphene flakes. Since the containment layer is not relied upon to support themselves as the mechanical strength is provided by the boron nitride nanotubes, but rather to only to occasionally contain n-BN particles or fragments, the lifespan of the containment layer is much longer than if the material of the containment layer were required to be self-supporting.

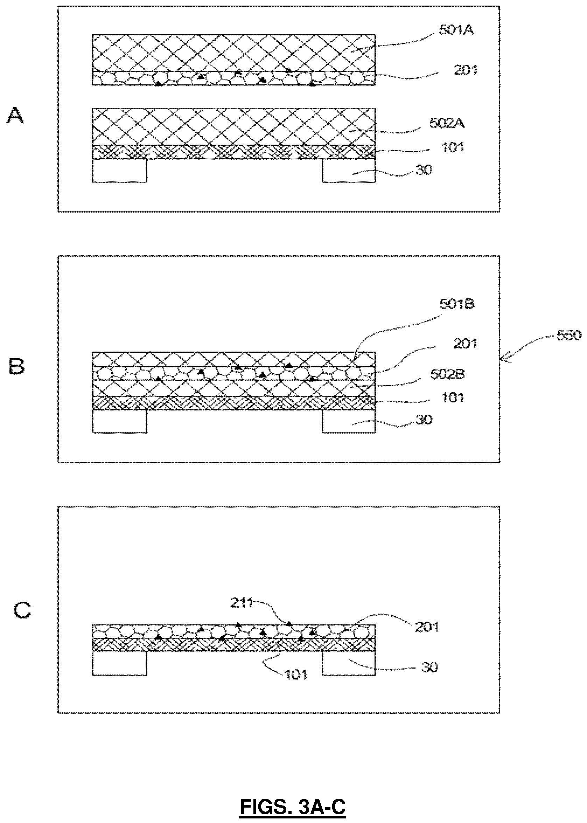

Figures 3A to 3C depict an exemplary process for manufacturing protective membranes according to the present disclosure. In Figure 3A, a boron nitride nanoparticle membrane 201 is provided on a carrier layer 501A. A containment layer 101 is provided on a carrier layer 502A. The containment layer 101 is depicted as being supported by frame 30, but this is optional and the frame may be provided at a later stage in the process. As shown in Figure 3B, the layers including carriers are brought together, subsequently the carrier layers are removed by sublimation or by etching to provide the protective membrane depicted in Figure 3C.

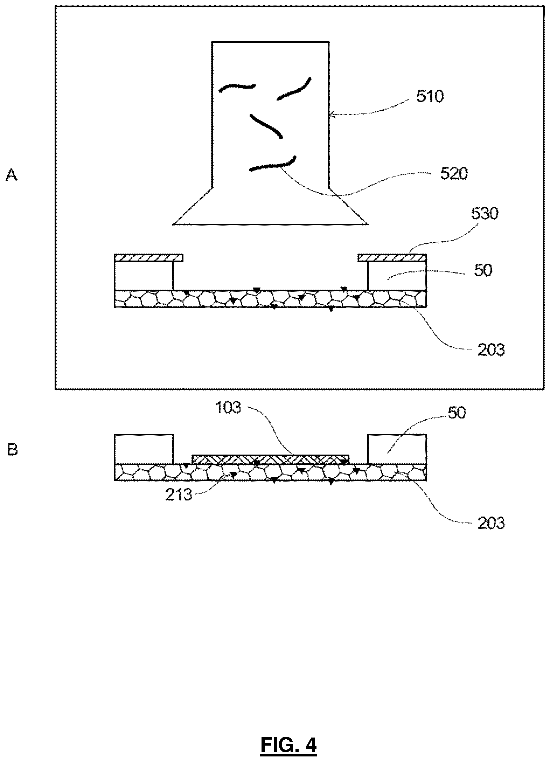

Figure 4 depicts an alternative process for providing a protective layer 103 onto a boron nitride nanotube layer 203. In this process, a CVD reactor 510 is provided and is configured to generate carbon nanotubes 520 from a carbon-containing feed gas, such as a hydrocarbon. A stream of gas carries the carbon nanotubes 520 and deposits them on the rear face (specifically the face which faces the reticle in use) of the boron nitride nanotube core 203. An optional mask 530 may be provided to prevent deposition of the carbon nanotubes onto the support frame 50.

While specific embodiments of the invention have been described above, it will be appreciated that the invention may be practiced otherwise than as described.

The descriptions above are intended to be illustrative, not limiting. Thus it will be apparent to one skilled in the art that modifications may be made to the invention as described without departing from the scope of the claims set out below.

## Claims

1. A protective membrane for an exposure apparatus for semiconductor manufacturing processes, the protective membrane comprising a boron nitride nanotube core and at least one containment layer configured to contain particles released from the core.

2. The protective membrane according to claim 1, wherein the containment layer is a porous layer, optionally wherein porous layer comprises one or both of carbon nanotubes and graphene flakes.

3. The protective membrane according to claim 1 or 2, wherein an intermediate layer is provided between the core and the containment layer.

4. The protective membrane according to any preceding claim, wherein the containment layer is a distinct layer or comprises a graduated composition.

5. The protective membrane according to any preceding claim, wherein the containment layer and/or core further comprises a capping layer.

6. The protective membrane according to claim 5, wherein the capping layer comprises a hydrogen-plasma etch resistant material.

7. The protective membrane according to claim 5 or 6, wherein the capping layer comprises one or more of aluminium oxide, zirconium oxide, yttrium oxide, and yttrium silicon oxide.

8. The protective membrane according to any preceding claim, wherein the protective membrane comprises boron nitride nanotubes and hexagonal boron nitride particles in a mass ratio of 50:1 or greater, 100:1 or greater, 250:1 or greater, 500:1 or greater, or 1000:1 or greater.

9. The protective membrane according to any preceding claim, wherein the porous layer extends at least at least 50%, at least 60%, at least 70%, at least 80%, at least 90%, or at least 95% of the membrane area, optionally over a quality area of the membrane, optionally wherein the porous layer extends over substantially the entire area of the membrane or over the entire area of the membrane.

10. The protective membrane according to any preceding claim, wherein the membrane has an EUV transmissivity of 85% or greater, 90% or greater, 93% or greater, or 95% or greater.

11. The protective membrane according to any preceding claim, the core having a first face and a second face, wherein the containment layer is provided on the first face, or wherein both the first face and the second face comprise a containment layer configured to contain particles released from the core.

12. The protective membrane according to any preceding claim, wherein the containment layer is a uniform layer or a patched layer.

13. A component of an exposure apparatus for semiconductor manufacturing processes comprising the protective membrane according to any of claims 1 to 12.

14. The component according to claim 13, wherein the component is a pellicle or a dynamic gas lock, a fiducial, a sensor, an optical element, a shield, or a reticle masking blade assembly component.

15. The component according to claim 13 or 14, wherein the optical element is a mirror, optionally a MEMS mirror.

16. The component according to claim 13 or 14, wherein the component is a pellicle comprising a protective membrane according to any of claims 1 to 12 and a support frame.

17. An exposure apparatus for semiconductor manufacturing processes comprising a protective membrane according to any of claims 1 to 12 or a component according to any of claims 13 to 16.

18. An exposure apparatus according to claim 17, wherein the exposure apparatus is a lithographic apparatus, a metrology apparatus, or an inspection apparatus.

19. An exposure apparatus according to claim 17 or 18, wherein the exposure apparatus is an EUV lithographic apparatus.

20. A method of manufacturing a protective membrane for an exposure apparatus for semiconductor manufacturing processes, the method including:
i) providing a core film, optionally a boron nitride nanotube core film, and
ii) providing a first containment layer configured to contain any particles released from the core film in use on a first face of the core film.

21. The method according to claim 20, wherein the containment layer in step ii) is provided via one or more of a) spray coating, b) chemical vapour deposition, c) solid carrier deposition, and d) liquid carrier deposition.

22. The method according to claim 21, wherein during liquid carrier deposition, the composition of the liquid carrier is changed during deposition to provide a graduated protective membrane.

23. The method according to claim 21, wherein following solid carrier deposition, the solid carrier is removed, optionally wherein the solid carrier is removed by melting, sublimation, or etching.

24. The method according to claim 21, wherein during liquid carrier deposition, the density of one or both of the core film and the containment layer are adjusted, optionally wherein the density is adjusted by controlling the pressure or flow rate of the liquid carrier.

25. The method according to any of claims 20 to 24, wherein the method further includes providing a second containment layer configured to contain any particles released from the core film in use on the core film, optionally wherein the second containment layer is provided on a face of the core film opposite to the first containment layer.

26. The method according to any of claims 20 to 25, wherein the method further includes providing a capping layer, optionally comprising one or more of aluminium oxide, zirconium oxide, yttrium oxide, and yttrium silicon oxide.

27. The method according to any of claims 20 to 26, wherein the method further includes providing an intermediate layer between the core film and at least one containment layer.

28. The method according to claim 21 part a), wherein the diameter of the droplets is 100µm or less, optionally 10µm or less, and/or the concentration of coating material within droplets is 1 mg/cm³ or less, optionally 0.1 mg/cm³ or less.

29. A method of reconditioning a boron nitride nanotube protective membrane for an exposure apparatus for semiconductor manufacturing processes, the method including removing at least a portion of any materials other than the boron nitride nanotubes.

30. The method according to claim 29, wherein the method includes etching, reducing, or oxidising at least a portion of any materials other than the boron nitride nanotubes to remove such materials from the membrane.

31. The method according to claim 29 or 30, wherein the method further includes providing a first containment layer configured to contain any particles released from the boron nitride nanotubes in use on the boron nitride nanotubes.

32. The use of a protective membrane, component, exposure apparatus or method according to any of claims 1 to 31 in a semiconductor manufacturing process or apparatus therefor.
